(19) **Europäisches Patentamt European Patent Office Office européen des brevets**

(11) **EP 1 269 660 B1**

(12) **EUROPEAN PATENT SPECIFICATION**

(45) Date of publication and mention of the grant of the patent:
**18.04.2012 Bulletin 2012/16**

(51) Int Cl.:
*H04B 10/00* (2006.01)   *H03K 17/795* (2006.01)
*H03K 17/08* (2006.01)   *H02H 9/00* (2006.01)

(21) Application number: **01906671.1**

(22) Date of filing: **25.01.2001**

(86) International application number:
**PCT/US2001/002416**

(87) International publication number:
**WO 2001/076107 (11.10.2001 Gazette 2001/41)**

(54) **OPTOCOUPLER FOR A NON-INTRINSICALLY SAFE CIRCUIT**

OPTOKOPPLER FÜR EINE NICHTEIGENSICHEREN SCHALTUNG

OPTOCOUPLEUR POUR CIRCUIT A SECURITE NON INTRINSEQUE

(84) Designated Contracting States:
**CH DE GB LI**

(30) Priority: **31.03.2000 US 541129**

(43) Date of publication of application:
**02.01.2003 Bulletin 2003/01**

(73) Proprietor: **Micro Motion, Inc.
Boulder, CO 80301 (US)**

(72) Inventors:
• **MANSFIELD, William, M.
Lafayette, CO 80026 (US)**
• **MCANALLY, Craig, B.
Thornton, CO 80241 (US)**

(74) Representative: **Holmes, Matthew William et al
Ollila Law Limited
First Floor
Unit 5
The Courtyard
Wixford Park
Bidford on Avon
Warwickshire B50 4JS (GB)**

(56) References cited:
**EP-A- 0 379 320     US-A- 5 014 156
US-A- 5 838 018**

## Description

Field Of The Invention

This invention relates to transmitting data from intrinsically safe circuits to non-intrinsically safe circuits. More particularly, this invention relates an opto-coupler used to transmit data between the circuits. Still more particularly, this invention relates to circuitry connected to a photo transistor to prevent excess energy from being applied to the opto-coupler.

Problem

Opto-couplers comprising an LED and an associated photo-transistor fabricated together as a single device are known and are widely used in applications in which DC and AC isolation must be maintained between a signal source and a signal output representing an amplified or processed input signal. Opto-couplers are used in instances in which the isolation provided by capacitance coupling between an input and an output circuit is not sufficient.
One such instance in which capacitance coupling is not sufficient is in applications in which the input and output circuits are operated in hazardous locations in which the safety provided by capacitance coupling alone is not sufficient. In such instances, it is well known to use opto-coupler circuitry in which an LED receives an input signal to be amplified or otherwise processed and, in so doing, generates an optical output signal representative of the received input signal. The LED is part of a device package that also includes a photo-transistor whose base receives the optical output of the LED and, in turn, controls the collector current of the photo-transistor. The photo-transistor may be advantageously operated as an amplifier whose output is developed across a collector resistor.
An opto-coupler operated in this manner provides increased isolation compared to that provided by the capacitor coupled transistor amplifier. The isolation provided by an opto-coupler is needed to connected intrinsically safe circuitry to non-intrinsically safe circuits. Intrinsically safe circuits are circuits that operate under a certain low energy level. By operating under a certain energy level, the circuitry is ensured not to generate a spark or sufficient heat to cause an explosion of material in a hazardous environment even if the circuitry fails in some manner. The power level needed to make circuitry intrinsically safe is determined by regulatory agencies such as the UL in the United States, CENELEC in Europe, CSA in Canada, and THS in Japan.
In order to be intrinsically safe, the intrinsically safe circuit must have a galvanic isolation barrier between the intrinsically safe circuit and circuitry that is not intrinsically safe. In order to transmit digital data across the galvanic isolation barrier, a large number of safety components are needed. In an opto-coupler, either the LED or the photo transistor is part of the intrinsically safe circuit.
In a common emitter configuration, the photo transistor saturates and an output voltage from the photo transistor is equal to a saturation voltage of a collector of the photo transistor when the photo transistor is activated by the LED. When the photo transistor is inactive, the output voltage is equal to a power supply voltage. In operation the terminals connected to the photo transistor must not exceed two thirds (2/3) of the maximum current, voltage, or power rating of the opto-coupler. To prevent the terminals connected to the photo transistor from exceeding the maximums, a zener diode and suitably rated fuse connected to a terminal is typically considered sufficient protection for the terminals. A resistor is also commonly added to prevent against the breaking capacity of the fuse. In this configuration, the diode and fuse are connected to the collector and power supply for the photo transistor. The result is that no path from the signal pins to ground goes through the fuse. Therefore the fuse is not needed on all three connections. As the cost of components increases and the board size of circuits decreases, there is a need to configure such circuits in a manner that reduces board cost.
FIG. 11 of EPO Application Serial 379 320 discloses a photo coupler circuit in which the main current path of the photo coupler (2) is connected via a resistor (3) to one side of a power supply (15) whose other side is connected to the other side of the main current path of the photo transistor. The resistor (3) is connected in parallel with the base emitter path of a switching transistor (11) so as to optimize the voltage of across the main current path of the photo transistor and to minimize carrier accumulation in the switching transistor. This results in obtaining fast switching of the output device arranged to receive output voltage ($V_0$) and enables the use of a general purpose photo coupler of relatively small size and low cost.
U.S. Patent No. 5,838,018 to Mansfield discloses an opto coupler circuit including a driver transistor, wherein an output signal is generated at the output of the driver transistor.
U.S. Patent No. 5,014,156 to Bruch discloses a fused electrical safety barrier including a voltage limiting circuit 10 and a current limiting circuit 15. Bruch includes an encapsulated fuse 9 in the voltage limiting circuit 10.

SOLUTION

The above and other problems are solved and an advance in the art is made by the protection circuitry of this invention. The circuitry reduces the number of node connections for a phototransistor to two nodes. Therefore, protection can be provided by a single Zener diode, fuse and resistor. This reduces the number of components needed which in turn reduces board cost and board area needed.

In accordance with this invention, the power supply connection to the photo transistor and a collector of the photo transistor are reduced to a single node. Collector-emitter current is then impressed across an output resistor to toggle a data line. The power connection and emitter are reduced to a single node using a resistor divider between the power connection and emitter. The use of the resistor divider allows the opto-coupler to remain powered by a dedicated supply current.

The present invention therefore provides a circuit for coupling an intrinsically safe circuit to a non-intrinsically safe circuit, comprising:

an opto-coupler including a photo transistor;
a resistor connecting a collector of said photo transistor to a power source for said photo transistor;
a fuse connecting a power supply to said power source;
a fuse resistor connected between said fuse and said power source;
an output resistor connected between an emitter of said photo transistor and ground; and
a zener diode;
wherein
a cathode of said diode is connected to said power supply via said fuse resistor and said fuse;
an anode of said diode is connected to an ungrounded first side of said output resistor; and
an emitter current of said photo transistor is arranged to generate an output signal across said output resistor.

Preferably, the circuit comprises a power supply resistor to limit a voltage of power applied to said power source of said photo transistor.

Preferably said power supply resistor is connected between said power source and said fuse resistor.

Preferably a ground resistor connecting said power source and ground at the junction of said power supply resistor, said diode, and said fuse resistor.

Preferably said output resistor is a 604 ohms resistor.

Preferably said power supply provides 14 volts of electricity.

Preferably said resistor divider is a 1.0 kilo ohms resistor.

Preferably said fuse is a 63 milliamp fuse.

Preferably said ground resistor is a 49.9 kilo Ohms resistor.

Preferably said fuse resistor is a 6.2 Ohms resistor.

Preferably said diode is a 16. Volt diode.

Preferably said circuitry having an intrinsically safe side and a non-intrinsically safe side, said circuitry receives an input signal on said intrinsically safe side to switch an output signal on the ungrounded side of resistor on said non-intrinsically safe side between a first state and a second state,
said opto-coupler having an active state and an inactive state,
said input signal receives multi-state input signals to switch said opto-coupler between said states;
said opto-coupler is effective when in said first state to apply a first signal to an output on the ungrounded side of resistor;
said opto-coupler is effective when in said second state to apply a second signal to said output on the ungrounded side of resistor;
said non-intrinsically safe side of said circuit comprises:

said power supply;
a first series circuit including said fuse resistor connected between said power supply and said output on the ungrounded side of resistor;
said first series circuit is effective when said opto-coupler is inactive to apply a current to said output in series with said output resistor to ground to generate the first signal on the ungrounded side of resistor;

said non-intrinsically safe side of the circuit further comprises:

a second series circuit including a said resistor divider and an output side of said opto-coupler connected between said power supply and said output on the ungrounded side of resistor;
said second series circuit is effective when said opto-coupler is active to apply a relatively high current to said output resistor to apply a second signal to said output on said ungrounded side of resistor.

Preferably said zener diode limits the voltage of the power supply to a predetermined magnitude;

said first series circuit comprises:

said fuse resistor that has a first side connected via side fuse to the first side of said power supply;

said diode having a cathode connected to a second side of said fuse resistor and having an anode connected to the output on said ungrounded side of resistor, the diode limits the magnitude of the voltage from the power supply to a predetermined magnitude;

said second series circuit comprises;

said power supply resistor having a first end connected to the cathode of the diode;

said resistor divider having a first end connected to a second end of the power supply resistor and having a second end connected to the collector of the opto-coupler;

said opto-coupler has an emitter element connected to said output on said ungrounded side of resistor;

said opto-coupler is inactive when in said first state so current from said power supply and through said second series circuit to said output on said ungrounded side of resistor applies a first voltage signal to said output across said output resistor;

said opto-coupler is active when in a second state so that current from said power supply and through a series path comprising said fuse resistor, said power supply resistor and said resistor divider and said opto-coupler apply a second voltage to said output across said load resistor.

Preferably a light emitting diode that receives the input signal from the intrinsically safe side of the circuit and generates an optical control signal in response to the reception of the input signal; and
a phototransistor in said second series circuit, that receives an optical control signal in response to the generation of the optical input signal to control the magnitude of a current from the power supply to the output and in turn to control the voltage across the load resistor.

## Description of the Drawings

The above and other aspects of this invention are described in the detailed description and the following drawings:

FIG. 1 illustrating a prior art opto-coupler and protection circuitry; and
FIG. 2 illustrating an opto-coupler and protection circuitry in accordance with this invention.

## Detailed Description

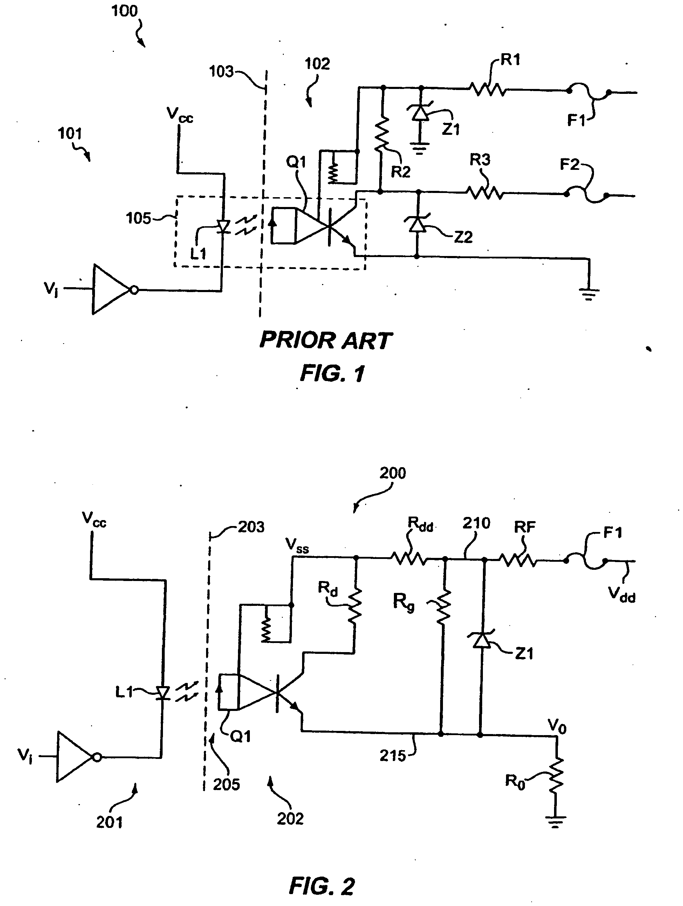

FIG. 1 illustrates prior art circuitry 100 that includes intrinsically safe circuit 101 and non-intrinsically safe circuit 102. Galvanic isolation barrier 103 provides a separation between intrinsically safe circuit 101 and non-intrinsically safe circuit 102 that separates the two circuits for purposes of safety ratings. Light Emitting Diode (LED) L1 and photo transistor Q1 form an opto-coupler 105 that passes digital signals from intrinsically safe circuit 101 to non-intrinsically safe circuit 102.

Opto-coupler 105 is a conventional opto-coupler such as a Hewlett Packard HCNW 4506 opto-coupler. In order to transmit data, LED L1 transmits light signals that are received by photo transistor Q1 and that activate and deactivate Q1. When Q1 is activated, photo transistor saturates with power from power supply $V_{dd}$. When saturated an output voltage Vo is equal to a collector-emitter saturation voltage of photo transistor Q1. When photo transistor Q1 is deactivated, output voltage Vo is pulled up to Vdd. A power supply connection to Q1 remains biased to Vdd.

In accordance to standards, such as Cenelec document EN 50020 titled "Electrical Apparatus for potentially explosive atmospheres-Intrinsic Safety," non-intrinsically safe terminal of an opto-coupler must have protective circuitry that insures the opto-coupler does not exceed two-thirds of a maximum current, voltage, or power rating. In the prior art, two of three nodes of photo transistor Q1 must be protected. As long as two of the three are protected there is no path the current can flow through that does not go through the fuse.

In order to protect a power supply node for photo transistor Q1, fuse F1, is connected between a power supply and the power supply node. Fuse F1 is a fuse having a rating that is suited for sufficient protection. Diode Z1 is connected to ground and between the power supply node and fuse F1. Resistor R1 is connected between fuse F1, the power supply node, and diode Z1 to protect against the breaking capacity of the fuse.

A collector node of photo transistor Q1 supplies Vo. The collector node is connected to the power supply node by resistor R2. Fuse F2 is also connected to the collector node. Diode Z2 connects the collector node of photo transistor Q1 to ground. Resistor R3 is connected between the collector node and fuse F2 and protects against the breaking capacity of the fuse. An emitter node of photo transistor Q1 is connected to ground and to diode Z2. From the above discussion, it can be seen that the power supply node and collector node are protected in non-intrinsically safe circuit 102.

**EP 1 269 660 B1**

FIG. 2 illustrates an exemplary embodiment of circuitry having protection circuitry in accordance with the present invention. The circuitry of this invention reduces the number of nodes in order to reduce the number of components needed to provide protection against the opto-coupler exceeding two thirds of the maximum voltage, current or energy of the coupler. Circuit 200 includes intrinsically safe circuit 201 and non-intrinsically safe circuit 202. Galvanic isolation barrier 203 separates intrinsically safe circuit 201 and non-intrinsically safe circuit 202. LED L1 and photo transistor Q1 form opto-coupler 205. One exemplary opto-coupler is a HCNW 4506 opto-coupler produced by Hewlett Packard. Opto-coupler 205 transmits data over the galvanic isolation barrier 203 between intrinsically safe circuit 201 and non-intrinsically safe circuit 202.

Photo transistor Q1 has a power supply node, a collector node and an emitter node. A power supply is connected to the power supply node. A fuse F1 is in path 210 between a power supply and fuse resistor Rf. Fuse Resistor Rf in path 210 is connected between Fuse F1 and the power supply node. The breaking capacity of fuse F1 is protected by fuse resistor Rf. Zener diode Z1 connects path 210 to ground via path 215. Zener diode Z1 is connected to path 210 between power supply resistor Rdd and fuse resistor Rf. A ground resistor Rg connects path 210 and path 215 between power supply resistor Rdd and fuse resistor Rf.

Path 210 may also include power supply resistor Rdd that regulates the amount of electricity supplied to opto-coupler 205. Power supply resistor Rdd is connected between the power supply node and the fuse resistor Rf in path 210. The collector of photo transistor Q1 is connected to divider resistor Rd. Divider resistor Rd connects the collector to path 210 between the power supply node and power supply resistor Rdd. The connection of the collector of photo transistor Q1 to path 210 allows a single fuse and a single Zener diode to provide protection to photo coupler 205.

Path 215 connects an emitter node of photo transistor to ground. Output resistor in path 215 is connected between the emitter and ground. Ground resistor Rg is connected to path 215 between the emitter and output resistor Ro. Zener diode Z1 is connected to path 215 in parallel to ground resistor Rg between the emitter and output resistor.

In a preferred embodiment, opto-coupler 205 is a HCNW 4506 produced by Hewlett Packard. According to Cenelec document EN 50020, this opto-coupler 205 cannot exceed two thirds of the values shown in the following table.

| Parameter | Symbol | Maximum | Units |
|---|---|---|---|
| Output Current | Io | 15 | mA |
| Resistor Voltage | Vr | Vss | Volts |
| Output Voltage | Vo | 30 | Volts |
| Supply Voltage | Vss | 30 | Vo |

The following table includes the values of the components of non-intrinsically safe circuit 201 for a preferred exemplary embodiment. These values will be used in the description below to determine the values of voltage and current being applied to opto-coupler 205 and being output be photo transistor Q1.

| Component | Symbol | Value | Units |
|---|---|---|---|
| Power Supply | Vdd | 14.0 | Volts |
| Fuse | F1 | 63 | mA |
| Fuse Resistor | Rf | 6.2 | Ohms |
| Supply Resistor | Rdd | 1.21K | Ohms |
| Divider Resistor | Rd | 1.0K | Ohms |
| Ground Resistor | Rg | 49.9K | Ohms |
| Output Resistor | Ro | 604 | Ohms |
| Zener Diode | 21 | 16.0 | Volts |

The output voltage is determined in the following manner. When photo transistor Q1 is not receiving light signals from LED L1 and is inactive, current from the power supply is limited to .6 mA. As a result, the output voltage can be determined from the following equation.

5

$$v_o = \left( \frac{v_{dd}}{R_f + R_g + R_o} + I_{cch} \right) R_o \quad (1)$$

When the values from the table of component values are inserted into Equation 1, the output voltage when the transistor Q1 is inactive can be determined to be .53 volts. This is well under the values of 20 volts required.

When photo transistor is receiving signals from LED L1 and is active, photo transistor conducts current and the output voltage is determined by the following equation.

$$v_o = v_{dd} \left( \frac{R_o}{R_f + R_o + \dfrac{R_g(R_{dd} + R_d)}{R_d + R_{dd} + R_g}} \right) \quad (2)$$

By inserting values from the table of component values, the output voltage for a preferred embodiment when photo transistor Q1 is active is 3.10 Volts which is well under two thirds of the maximum output voltage given in the table of maximum ratings for opto-coupler 205.

The voltage of power from the power supply, Vss, varies according to whether photo transistor Q1 is active or inactive. When photo transistor is receiving signals from LED L1 and is active, Vss is equal to the current flowing through divider resistor Rd. From equation 2, the current flowing through divider resistor Rd is:

$$I_{Rd} = \frac{(V_{dd} - V_o)}{\dfrac{R_g(R_{dd} - R_d)}{R_g + R_{dd} + R_d}} \quad (3)$$

By inserting values from the table of component values and table of maximum values, the current flowing through the divider resistor is 5.15 mA which gives a supply voltage Vss of 5.15 volts.

In this embodiment, supply voltage Vss, resistor voltage Vr, and output voltage Vo are limited by Zener diode Z1. Therefore Zener diode Z1 must limit to less than two-thirds of the maximum supply voltage which from the table of maximums may be determined to be 20 Volts in a preferred embodiment. Fuse F1 limits the current from the power supply to prevent Zener diode Z1 from exceeding the two thirds power of the maximum supply voltage.

In the preferred embodiment, zener diode Z1 has a rating of 3.0 watts which means that the maximum power through the Zener diode must be limited to 2.0 watts. The power through Zener diode Z1 may be calculated in the following manner.

$$P_{zener} = 1.7 \times I_{F1} \times V_{z\,max} \quad (4)$$

Where Vzmax is a voltage rating of Zener diode Z1 plus the tolerance Zener diode Z1 (5%) and a multiplier of 1.7 as required by Cenelec document En 50020 for circuits that include a fuse. Zener diode Z1 has a rating of 3.0 Watts which means that the maximum voltage power through the Zener diode must be limited to 2.0 Watts. In the preferred embodiment, the maximum power through Zener diode Z1 is 1.8 Watts.

The breaking capacity of the fuse must also be protected. In a preferred embodiment, the breaking capacity of fuse F1 is 50 A and fuse F1 is rated at 250 Volts. Since the value of fuse resistor Rf is 6.2 Ohms as given in the table of component values, the current of fuse F1 is limited to 250 Volts divided by 6.2 Ohms or 40.3 A.

The last parameter which must be protected is the current through the collector of photo transistor Q1. The maximum current is reached when photo transistor Q1 is active. The maximum current can be determined by dividing the result of equation 4 by the output resistor Ro value.

$$I_{collector} = \frac{1.7 \times I_{fuse} \times V_{z\,max}}{R_o} \quad (5)$$

In a preferred embodiment, output current Io is 5.13 mA when values from the tables of maximums and component values are inserted. This is less than two thirds of the maximum value for output current Io which is 10mA.

**Claims**

1. Circuitry (200) that prevents an opto-coupler (205) from exceeding a particular power rating, comprising:

   a divider resistor ($R_d$) connecting a collector of a photo transistor ($Q_1$) to a power source ($V_{ss}$) for said photo transistor;
   a fuse (F1) connecting a power supply ($V_{dd}$) to said power source ($V_{ss}$) and to said divider resistor ($R_d$);
   a fuse resistor (RF) connected between said fuse and power source ($V_{ss}$) of said photo transistor and said divider resistor; and
   a Zener diode (Z1);
   wherein a cathode of said Zener diode (Z1) is connected in series with said fuse resistor (RF) and said fuse (F1) to said power supply ($V_{dd}$);
   **characterized in that**:

   said circuitry further comprises an ungrounded first side of output resistor ($R_0$) directly connected to both an anode of said Zener diode (Z1) and further directly connected to the emitter of said photo transistor; and said output resistor ($R_0$) has a second side directly connected to ground, and wherein the emitter current of said photo transistor is arranged to generate an output signal ($V_o$) across said output resistor ($R_0$).

2. The circuitry (200) of claim 1 further comprising:

   a power supply resistor ($R_{dd}$) to limit a voltage of power applied to said power source ($V_{ss}$) of said photo transistor ($Q_1$).

3. The circuitry of claim 2 wherein said power supply resistor ($R_{dd}$) is connected between said power source ($V_{ss}$) and said fuse resistor (RF).

4. The circuitry of claim 2 or claim 3 further comprising:

   a ground resistor ($R_g$) connecting said power source and ground at the junction of said power supply resistor ($R_{dd}$), said Zener diode (Z1), and said fuse resistor (RF).

5. The circuitry of any preceding claim wherein said output resistor ($R_o$) is a 604 ohms resistor.

6. The circuitry of claim 4 or claim 5 wherein said power supply ($V_{dd}$) provides 14 volts of electricity.

7. The circuitry of any of claims 4 to 6 wherein said divider resistor ($R_d$) is a 1.0 kilo ohms resistor.

8. The circuitry of any of claims 4 to 7 wherein said fuse (F1) is a 63 milliamp fuse.

9. The circuitry of any of claims 4 to 8 wherein said ground resistor ($R_g$) is a 49.9 kilo Ohms resistor.

10. The circuitry of any of claims 4 to 9 wherein said fuse resistor (RF) is a 6.2 Ohms resistor.

11. The circuitry of any of claims 4 to 10 wherein said Zener diode (Z1) is a 16 Volt diode.

12. The circuitry of any preceding claim wherein:

   said circuitry (200) comprises an intrinsically safe side (201) and a non-intrinsically safe side (202), said circuitry being arranged to receive an input signal ($V_i$) on said intrinsically safe side to switch an output signal ($V_o$) on the ungrounded side of output resistor ($R_0$) on said non-intrinsically safe side between a first state and a second state,

said opto-coupler (205) has an active state and an inactive state;

said input signal ($V_i$) is arranged to switch said opto-coupler between said active and inactive states;

said opto-coupler is effective when active to apply a first signal to an output ($V_o$) on the ungrounded side of output resistor ($R_0$);

said opto-coupler is effective when inactive to apply a second signal to said output ($V_o$) on the ungrounded side of output resistor ($R_0$); and

wherein said non-intrinsically safe side of said circuit comprises:

said power supply ($V_{dd}$); and

a first series circuit including said fuse resistor (RF) connected between said power supply ($V_{dd}$) and said output ($V_o$) on the ungrounded side of resistor ($R_0$); and

wherein said first series circuit is effective when said opto-coupler is inactive to apply a current to said output ($V_o$) in series with said output resistor ($R_0$) to ground to generate the first signal on the ungrounded side of output resistor ($R_0$).

**13.** The circuitry of claim 12, wherein:

said non-intrinsically safe side of the circuit further comprises a second series circuit ($R_{dd}$, $R_d$) including said divider resistor ($R_d$) and an output side of said opto-coupler connected between said power supply ($V_{ss}$) and said output ($V_o$) on the ungrounded side of output resistor ($R_0$); and

wherein said second series circuit is effective when said opto-coupler is active to apply a current to said output resistor ($R_0$) to apply a second signal to said output ($V_o$) on said ungrounded side of output resistor ($R_0$).

**14.** The circuitry of claim 12 or claim 13:

wherein said Zener diode (Z1) is arranged to limit the voltage of the power supply ($V_{dd}$) to a predetermined magnitude;

wherein said first series circuit comprises;

said fuse resistor (RF) that has a first side connected via fuse (F1) to the first side of said power supply ($V_{dd}$); and

said Zener diode having a cathode connected to a second side of said fuse resistor (RF) and having an anode connected to the output ($V_o$) on said ungrounded side of output resistor ($R_0$);

wherein said second series circuit comprises;

said power supply resistor ($R_{dd}$) having a first end connected to the cathode of the Zener diode;

said divider resistor ($R_d$) having a first end connected to a second end of the power supply resistor ($R_{dd}$) and having a second end connected to the collector of the opto-coupler; and

said opto-coupler having an emitter element connected to said output ($V_o$) on said ungrounded side of resistor ($R_0$);

wherein when said opto-coupler is inactive current from said power supply ($V_{dd}$) and through said second series circuit to said output ($V_o$) on said ungrounded side of output resistor ($R_0$) applies a first voltage signal to said output ($V_o$) across said output resistor ($R_0$); and

wherein when said opto-coupler is active current from said power supply ($V_{dd}$) and through a series path comprising said fuse resistor (RF), said power supply resistor ($R_{dd}$) and said divider resistor ($R_d$) and said opto-coupler apply a second voltage to said output across said load resistor ($R_0$).

**15.** The opto-coupler of any of claims 12 to 14 comprising:

a light emitting diode (202) that receives the input signal from the intrinsically safe side of the circuit and generates an optical control signal in response to the reception of the input signal; and

a phototransistor (202) in said second series circuit, that receives an optical control signal in response to the generation of the optical input signal to control the magnitude of a current from the power supply to the output and in turn to control the voltage across the load resistor.

**Patentansprüche**

1. Schaltungsanordnung (200), die verhindert, dass ein Optokoppler (205) einen bestimmten Leistungswert übersteigt, und die Folgendes umfasst:

   einen Teilerwiderstand ($R_d$), der einen Kollektor eines Fototransistors ($Q_1$) mit einer Stromquelle ($V_{ss}$) für den genannten Fotoresistor verbindet;
   eine Sicherung (F1), die eine Stromversorgung ($V_{dd}$) mit der genannten Stromquelle ($V_{ss}$) und dem genannten Teilerwiderstand ($R_d$) verbindet;
   einen Sicherungswiderstand (RF), der zwischen der genannten Sicherung und der Stromquelle ($V_{ss}$) des genannten Fototransistors und des genannten Teilerwiderstands geschaltet ist; und
   eine Zener-Diode (Z1);
   wobei eine Kathode der genannten Zener-Diode (Z1) mit der genannten Stromversorgung ($V_{dd}$) in Serie mit dem genannten Sicherungswiderstand (RF) und der genannten Sicherung (F1) geschaltet ist;
   **dadurch gekennzeichnet, dass**:

   die genannte Schaltungsanordnung ferner eine ungeerdete erste Seite des Ausgangswiderstands ($R_o$) umfasst, die direkt mit einer Anode der genannten Zener-Diode (Z1) und ferner direkt mit dem Emitter des genannten Fototransistors verbunden ist; und
   der genannte Ausgangswiderstand ($R_o$) eine zweite Seite hat, die direkt mit Erde verbunden ist, und wobei der Emitterstrom des genannten Fototransistors zum Erzeugen eines Ausgangssignals ($V_o$) über den genannten Ausgangswiderstand ($R_o$) ausgelegt ist.

2. Schaltungsanordnung (200) nach Anspruch 1, die ferner Folgendes umfasst:

   einen Stromversorgungswiderstand ($R_{dd}$) zum Begrenzen der Spannung von Strom, der zu der genannten Stromquelle ($V_{ss}$) des genannten Fototransistors ($Q_1$) gespeist wird.

3. Schaltungsanordnung nach Anspruch 2, wobei der genannte Stromversorgungscaiderstand ($R_{dd}$) zwischen der genannten Stromquelle ($V_{ss}$) und dem genannten Sicherungswiderstand (RF) geschaltet ist.

4. Schaltungsanordnung nach Anspruch 2 oder Anspruch 3, die ferner Folgendes umfasst:

   einen Erdwiderstand ($R_g$), der die genannte Stromquelle und Erde am Übergang zwischen dem genannten Stromversorgungswiderstand ($R_{dd}$), der genannten Zener-Diode (Z1) und dem genannten Sicherungswiderstand (RF) verbindet.

5. Schaltungsanordnung nach einem der vorherigen Ansprüche, wobei der genannte Ausgangswiderstand ($R_o$) ein 604 Ohm Widerstand ist.

6. Schaltungsanordnung nach Anspruch 4 oder Anspruch 5, wobei die genannte Stromversorgung ($V_{dd}$) Strom mit 14 Volt bereitstellt.

7. Schaltungsanordnung nach einem der Ansprüche 4 bis 6, wobei der genannte Teilerwiderstand ($R_d$) ein 1,0 Kiloohm Widerstand ist.

8. Schaltungsanordnung nach einem der Ansprüche 4 bis 7, wobei die genannte Sicherung (F1) eine 63 mA Sicherung ist.

9. Schaltungsanordnung nach einem der Ansprüche 4 bis 8, wobei der genannte Erdwiderstand ($R_g$) ein 49,9 Kilochm Widerstand ist.

10. Schaltungsanordnung nach einem der Ansprüche 4 bis 9, wobei der genannte Sicherungswiderstand (RF) ein 6,2 Ohm Widerstand ist.

11. Schaltungsanordnung nach einem der Ansprüche 4 bis 10, wobei die genannte Zener-Diode (Z1) eine 16 Volt Diode ist.

**12.** Schaltungsanordnung nach einem der vorherigen Ansprüche, wobei:

die genannte Schaltungsanordnung (200) eine eigensichere Seite (201) und eine nicht eigensichere Seite (202) hat, wobei die genannte Schaltungsanordnung so ausgelegt ist, dass sie ein Eingangssignal ($V_i$) auf der genannten eigensicheren Seite empfängt, um ein Ausgangssignal ($V_o$) auf der ungeerdeten Seite des Ausgangswiderstands ($R_o$) auf der genannten nicht eigensicheren Seite zwischen einem ersten Zustand und einem zweiten Zustand zu schalten,
der genannte Optokoppler (205) einen aktiven Zustand und einen inaktiven Zustand hat;
das genannte Eingangssignal ($V_i$) so ausgelegt ist, dass es den genannten Optokoppler zwischen dem genannten aktiven und dem genannten inaktiven Zustand schaltet;
der genannte Optokoppler wenn aktiv die Aufgabe hat, ein erstes Signal an einen Ausgang ($V_o$) auf der ungeerdeten Seite des Ausgangswiderstands ($R_o$) anzulegen;
der genannte Optokoppler wenn inaktiv die Aufgabe hat, ein zweites Signal an den genannten Ausgang ($V_o$) auf der ungeerdeten Seite des Ausgangswiderstands ($R_0$) anzulegen; und
wobei die genannte nicht eigensichere Seite der genannten Schaltung Folgendes umfasst:

die genannte Stromversorgung ($V_{dd}$); und
eine erste Serienschaltung mit dem genannten Sicherungswiderstand (RF), der zwischen der genannten Stromversorung ($V_{dd}$) und dem genannten Ausgang ($V_o$) auf der ungeerdeten Seite des Widerstands ($R_o$) geschaltet ist; und
wobei die genannte erste Serienschaltung, wenn der genannte Optokoppler inaktiv ist, die Aufgabe hat, einen Strom an den genannten Ausgang ($V_o$) in Serie mit dem genannten Ausgangswiderstand ($R_o$) an Erde anzulegen, um das erste Signal auf der ungeerdeten Seite des Ausgangswiderstands ($R_o$) zu erzeugen.

**13.** Schaltungsanordnung nach Anspruch 12, wobei:

die genannte nicht eigensichere Seite der Schaltung ferner eine zweite Serienschaltung ($R_{dd}$, $R_d$) mit dem genannten Teilerwiderstand ($R_d$) und einer Ausgangsseite des genannten Optokopplers umfasst, die zwischen der genannten Stromversorgung ($V_{ss}$) und dem genannten Ausgang ($V_o$) auf der ungeerdeten Seite des Ausgangswiderstands ($R_o$) geschaltet ist; und
wobei die genannte zweite Serienschaltung, wenn der genannte Optokoppler aktiv ist, die Aufgabe hat, einen Strom zu dem genannten Ausgangswiderstand ($R_o$) zu speisen, um ein zweites Signal an den genannten Ausgang ($V_o$) auf der genannten ungeerdeten Seite des Ausgangswiderstands ($R_o$) anzulegen.

**14.** Schaltungsanordnung nach Anspruch 12 oder Anspruch 13:

wobei die genannte Zener-Diode (Z1) die Aufgabe hat, die Spannung der Stromversorgung ($V_{dd}$) auf eine vorbestimmte Größe zu begrenzen;
wobei die genannte erste Serienschaltung Folgendes umfasst:

den genannten Sicherungswiderstand (RF), dessen erste Seite über eine Sicherung (F1) mit der zweiten Seite der genannten Stromversorgung ($V_{dd}$) verbunden ist; und
wobei die genannte Zener-Diode eine Kathode hat, die mit einer zweiten Seite des genannten Sicherungswiderstands (RF) verbunden ist, und eine Anode hat, die mit dem Ausgang ($V_o$) auf der genannten ungeerdeten Seite des Ausgangswiderstands ($R_o$) verbunden ist;
wobei die genannte zweite Serienschaltung Folgendes umfasst:

den genannten Stromversorgungswiderstand ($R_{dd}$) mit einem ersten Ende, das mit der Kathode der Zener-Diode verbunden ist;
wobei der genannte Teilerwiderstand ($R_d$) ein erstes Ende hat, das mit einem zweiten Ende des Stromversorgungswiderstands ($R_{dd}$) verbunden ist, und ein zweites Ende hat, das mit dem Kollektor des Optokopplers verbunden ist; und
wobei der genannte Optokoppler ein Emitter-Element hat, das mit dem genannten Ausgang ($V_o$) auf der genannten ungeerdeten Seite des Widerstands ($R_o$) verbunden ist;
wobei, wenn der genannte Optokoppler inaktiv ist, Strom von der genannten Stromversorgung ($V_{dd}$) durch die genannte zweite Serienschaltung zu dem genannten Ausgang ($V_o$) auf der genannten ungeerdeten Seite des Ausgangswiderstands ($R_o$) ein erstes Spannungssignal an den genannten Ausgang ($V_o$) über den genannten

Ausgangswiderstand ($R_o$) anlegt; und

wobei, wenn der genannte Optokoppler aktiv ist, Strom von der genannten Stromversorgung ($V_{dd}$) durch einen seriellen Pfad, der den genannten Sicherungswiderstand (RF), den genannten Stromversorgungswiderstand ($R_{dd}$) und den genannten Teilerwiderstand ($R_d$) und den genannten Optokoppler umfasst, eine zweite Spannung an den genannten Ausgang über den genannten Lastwiderstand ($R_o$) anlegt.

**15.** Optokoppler nach einem der Ansprüche 12 bis 14, der Folgendes umfasst:

eine Leuchtdiode (202), die das Eingangssignal von der eigensicheren Seite der Schaltung empfängt und ein optisches Steuersignal als Reaktion auf den Empfang des Eingangssignals erzeugt; und

einen Fototransistor (202) in der genannten zweiten Serienschaltung, der ein optisches Steuersignal als Reaktion auf die Erzeugung des optischen Eingangssignals empfängt, um die Größe eines Stroms von der Stromversorgung zum Ausgang zu regeln und wiederum die Spannung über den Lastwiderstand zu regeln.

## Revendications

**1.** Circuiterie (200) qui empêche un photocoupleur (205) de dépasser une certaine puissance nominale, comprenant :

une résistance de division ($R_d$) connectant un collecteur d'un phototransistor ($Q_1$) à une source d'alinentation ($V_{ss}$) pour ledit phototransistor ;

un fusible (F1) connectant une alimentation électrique ($V_{dd}$) à ladite source d'alimentation ($V_{ss}$) et à ladite résistance de division ($R_d$) ;

une résistance fusible (RF) connectée entre ledit fusible et la source d'alimentation ($V_{ss}$) dudit phototransistor et ladite résistance de division ; et

une diode Zener (Z1) ;

dans laquelle une cathode de ladite diode Zener (Z1) est connectée en série avec ladite résistance fusible (RF) et ledit fusible (F1) à ladite alimentation électrique ($V_{dd}$) ;

**caractérisé en ce que** :

ladite circuiterie comprend en outre un premier côté non mis à la terre d'une résistance de sortie ($R_o$) directement connecté à une anode de ladite diode Zener (Z1) et en outre directement connecté à l'émetteur dudit phototransistor ; et

ladite résistance de sortie ($R_o$) a un deuxième côté directement connecté à la terre, et

dans laquelle le courant émetteur dudit phototransistor est conçu pour générer un signal de sortie ($V_o$) à travers ladite résistance de sortie ($R_o$).

**2.** Circuiterie (200) selon la revendication 1, comprenant en outre :

une résistance d'alimentation électrique ($R_{dd}$) pour limiter une tension d'alimentation appliquée à ladite source d'alimentation ($V_{ss}$) dudit phototransistor ($Q_1$).

**3.** Circuiterie selon la revendication 2, dans laquelle ladite résistance d'alimentation électrique ($R_{dd}$) est connectée entre ladite source d'alimentation ($V_{ss}$) et ladite résistance fusible (RF).

**4.** Circuiterie selon la revendication 2 ou la revendication 3, comprenant en outre :

une résistance de terre ($R_g$) connectant ladite source d'alimentation et la terre à la jonction de ladite résistance d'alimentation électrique ($R_{dd}$), ladite diode Zener (Z1), et ladite résistance fusible (RF).

**5.** Circuiterie selon l'une quelconque des revendications précédentes, dans laquelle ladite résistance de sortie ($R_o$) est une résistance de 604 Ohms.

**6.** Circuiterie selon la revendication 4 ou la revendication 5, dans laquelle ladite alimentation électrique ($V_{dd}$) apporte 14 volts d'électricité.

**7.** Circuiterie selon l'une quelconque des revendications 4 à 6, dans laquelle ladite résistance de division ($R_d$) est une résistance de 1,0 kOhm.

**8.** Circuiterie selon l'une quelconque des revendications 4 à 7, dans laquelle ledit fusible (F1) est un fusible de 63 milliampères.

**9.** Circuiterie selon l'une quelconque des revendication 4 à 8, dans laquelle ladite résistance de terre (R$_g$) est une résistance de 49,9 kOhms.

**10.** Circuiterie selon l'une quelconque des revendications 4 à 9, dans laquelle ladite résistance fusible (RF) est une résistance de 6,2 Ohms.

**11.** Circuiterie selon l'une quelconque des revendications 4 à 10, dans laquelle ladite diode Zener (Z1) est une diode de 16 volts.

**12.** Circuiterie selon l'une quelconque des revendications précédentes, dans laquelle :

    ladite circuiterie (200) comprend un côté à sécurité intrinsèque (201) et un côté non à sécurité intrinsèque (202), ladite circuiterie étant conçue pour recevoir un signal d'entrée (V$_i$) sur ledit côté à sécurité intrinsèque pour entraîner la commutation d'un signal de sortie (V$_o$) sur le côté non mis à la terre de la résistance de sortie (R$_o$) sur ledit côté non à sécurité intrinsèque entre un premier état et un deuxième état,
ledit photocoupleur (205) a un état actif et un état inactif ;
ledit signal d'entrée (V$_i$) est conçu pour entraîner la commutation dudit photocoupleur entre ledit état actif et ledit état inactif ;
ledit photoccuoleur est efficace, quand il est actif, pour appliquer un premier signal à une sortie (V$_o$) sur le côté non mis à la terre de la résistance de sortie (R$_o$) ;
ledit photocoupleur est efficace, quand il est inactif, pour appliquer un deuxième signal à ladite sortie (V$_o$) sur le côté non mis à la terre de la résistance de sortie (R$_o$) ; et
dans laquelle ledit côté non à sécurité intrinsèque dudit circuit comprend :

        ladite alimentation électrique (V$_{dd}$) ; et
un premier circuit en série comprenant ladite résistance fusible (RF) connectée entre ladite alimentation électrique (V$_{dd}$) et ladite sortie (V$_o$) sur le côté non mis à la terre de la résistance (R$_o$) ; et
dans laquelle ledit premier circuit en série est efficace, quand ledit photocoupleur est inactif, pour appliquer un courant à ladite sortie (V$_o$) en série avec ladite résistance de sortie (R$_o$) aboutissant à la terre pour générer le premier signal sur le côté non mis à la terre de la résistance de sortie (R$_o$).

**13.** Circuiterie selon la revendication 12, dans laquelle :

    ledit côté non à sécurité intrinsèque du circuit comprend en outre un deuxième circuit en série (R$_{dd}$, R$_d$) comprenant ladite résistance de division (R$_d$) et un côté sortie dudit photocoupleur connecté entre ladite alimentation électrique (V$_{ss}$) et ladite sortie (V$_o$) sur le côté non mis à la terre de la résistance de sortie (R$_o$) ; et
dans laquelle ledit deuxième circuit en série est efficace, quand ledit photocoupleur est actif, pour appliquer un courant à ladite résistance de sortie (R$_o$) afin d'appliquer un deuxième signal à ladite sortie (V$_o$) sur ledit côté non mis à la terre de la résistance de sortie (R$_o$).

**14.** Circuiterie selon la revendication 12 ou la revendication 13 :

    dans laquelle ladite diode Zener (Z1) est conçue pour limiter la tension de l'alimentation électrique (V$_{dd}$) à une grandeur prédéterminée ;
dans laquelle ledit premier circuit en série comprend :

        ladite résistance fusible (RF) qui a un premier côté connecté par l'intermédiaire d'un fusible (F1) au premier côté de ladite alimentation électrique (V$_{dd}$) ; et
ladite diode Zener comportant une cathode connectée à un deuxième côté de ladite résistance fusible (RF) et comportant une anode connectée à la sortie (V$_o$) sur ledit côté non mis à la terre de la résistance de sortie (R$_o$) ;
dans laquelle ledit deuxième circuit en série comprend :

ladite résistance d'alimentation électrique ($R_{dd}$) ayant une première extrémité connectée à la cathode de la diode Zener ;

ladite résistance de division ($R_d$) ayant une première extrémité connectée à une deuxième extrémité de la résistance d'alimentation électrique ($R_{dd}$) et ayant une deuxième extrémité connectée au collecteur du photocoupleur ; et

ledit photocoupleur comportant un élément émetteur connecté à ladite sortie ($V_o$) sur ledit côté non mis à la terre de la résistance ($R_o$) ;

dans laquelle, quand ledit photocoupleur est inactif, le courant provenant de ladite alimentation électrique ($V_{dd}$) et traversant ledit deuxième circuit en série jusqu'à ladite sortie ($V_o$) sur ledit côté non mis à la terre de la résistance de sortie ($R_o$) applique un premier signal de tension à ladite sortie ($V_o$) à travers ladite résistance de sortie ($R_o$) ; et

dans laquelle, quand ledit photocoupleur est actif, le courant provenant de ladite alimentation électrique ($V_{dd}$) et suivant un trajet en série comprenant ladite résistance fusible (RF), ladite résistance d'alimentation électrique ($R_{dd}$) et ladite résistance de division ($R_d$) et ledit photocoupleur appliquent une deuxième tension à ladite sortie à travers ladite résistance de charge ($R_o$).

15. Photocoupleur selon l'une quelconque des revendications 12 à 14, comprenant :

une diode électroluminescente (202) qui reçoit le signal d'entrée provenant du côté à sécurité intrinsèque du circuit et génère un signal de commande optique en réponse à la réception du signal d'entrée ; et

un phototransistor (202) dans ledit deuxième circuit en série, qui reçoit un signal de commande optique en réponse à la génération du signal d'entrée optique pour contrôler la grandeur d'un courant circulant de l'alimentation électrique à la sortie, en contrôlant ainsi la tension à travers la résistance de charge.

**PRIOR ART**

**FIG. 1**

**FIG. 2**

**EP 1 269 660 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 379320 A
- US 5838018 A, Mansfield
- US 5014156 A, Bruch